# EUROPÄISCHE PATENTSCHRIFT

(11) **EP 2 988 062 B1**
(45) Veröffentlichungstag und Bekanntmachung des Hinweises auf die Patenterteilung: **20.03.2019**
(21) Anmeldenummer: 15172373.1
(22) Anmeldetag: 28.12.2011
(51) Int. Cl.: F21V 14/00, F21Y 115/10

(54) **LEUCHTE**
LAMP
LUMINAIRE

(30) Priorität: 28.12.2010 CH 21882010
(43) Veröffentlichungstag der Anmeldung: 24.02.2016
(62) Teilanmeldung aus: 11195848.4
(73) Patentinhaber: Regent Beleuchtungskörper AG, 4018 Basel (CH)
(72) Erfinder: Hess, Jean-Marc, 4142 Münchenstein (CH)
(74) Vertreter: Braun, André jr.

(56) Entgegenhaltungen:
- EP-A2- 1 248 033
- DE-A1-102012 201 494
- US-A1- 2003 107 323

## Beschreibung

Die Erfindung betrifft eine Leuchte gemäss dem Oberbegriff des unabhängigen Anspruchs 1 sowie ein entsprechendes Verfahren zum Lenken von Licht.

### Beschreibung

Aus dem Stand der Technik sind Leuchten der beschriebenen Art bekannt. So ist aus dem Dokument DE 102006023276 A1 eine Steckerdimmrichtleuchte bekannt, deren Lichtstrahl dimmbar und ausrichtbar ist, mit einem in der Nähe der Lichtaustrittsöffnung eingebauten elektrischen Leuchtkörper, wobei ein Reflektor zwischen Steckstiften und Leuchtkörper der Leuchte verschwenkbar angeordnet ist, wobei die erste Reflektorschwenkachse eine Linie kreuzt, die orthogonal von der Oberfläche des Reflektors aus entlang seiner Reflektionsachse verläuft und die Lichtaustrittsöffnung entweder mittels einer Verdunkelungsfläche und/oder durch den Reflektor und/oder in der Wirkung durch eine Verschwenkung des Leuchtkörpers auf die zur Innenseite des Gehäuses weisende Seite des Reflektors wenigstens teilweise abdeckbar ist.

Einer der Nachteile dieser Leuchte besteht darin, dass die Verschwenkung der Lichtaustrittsöffnung gegenüber dem Leuchtkörper voraussetzt, dass der Leuchtkörper im Wesentlichen im Innenraum, welcher vom Reflektor gebildet wird, angeordnet sein muss. Eine Beleuchtung der Umgebung findet somit nur durch reflektiertes Licht statt. Zudem gestaltet sich die mechanische Lösung zum Verschwenken des Leuchtkörpers als konstruktiv aufwändig.

Aus CH 697 541 B1 ist eine Leuchte mit mindestens einer elektrischen Lichtquelle sowie mit Licht-Reflexionsmitteln und/oder Licht-Verteilmitteln bekannt, wobei die Lichtquelle mehrere Leuchtdioden aufweist und wobei die Licht-Reflexion- und/oder Licht-Verteilmittel ausgebildet sind, um von den Leuchtdioden erzeugtes Licht zu reflektieren und/oder zu verteilen.

Die beschriebene Leuchte ist insbesondere darauf ausgelegt, mit wenig elektrischer Energie Licht zu erzeugen und einen relativ grossen Raumbereich einigermassen gleichmässig zu beleuchten, so dass sie beispielsweise bei einem Ausfall der Netzspannung für eine Not-Beleuchtung verwendbar ist.

Aus der EP 1248033 A2 ist eine Reflektorleuchte bekannt, die eine Lichtquelle L und einen Parabolreflektor zur Umlenkung von Lichtstrahlen der Lichtquelle aufweist. Der Reflektor ist bezüglich einer Symmetrieachse symmetrisch ausgebildet und vor der Lichtquelle angeordnet. Die Lichtquelle kann um einen Verschiebeweg relative zum Reflektor verschoben werden, um die Umlenkung der Lichtstrahlen zu steuern. Die Steuerung ist jedoch nur im Rahmen der optischen Parameter des Parabolreflektors möglich.

Es ist daher Aufgabe der vorliegenden Erfindung, eine Leuchte vorzuschlagen, welche die Nachteile des Stands der Technik nicht aufweist. Insbesondere soll eine für den zu beleuchtenden Bereich flexible Ausrichtung des Lichts ermöglicht werden.

Insbesondere wird die Aufgabe der Erfindung gelöst durch eine Leuchte, die sich durch die Merkmale des kennzeichnenden Teils des Anspruchs 1 auszeichnet.

Für den Zweck dieser Beschreibung wird der Begriff "Umlenkelement" für optische Komponenten verwendet, die einfallende Lichtstrahlen durch Reflexion, Refraktion und/oder Diffraktion unter einem vom Einfallswinkel verschiedenen Winkel abgeben. Beispiele solcher Umlenkelemente sind Reflektoren, Linsen, Gitter etc. Vielfach sind solche Umlenkelemente rotationssymmetrisch ausgebildet, wobei die Lichtquelle in der Regel in der Symmetrieachse angeordnet ist. Eine andere Form sind langgestreckte Reflektoren in Leuchten für röhrenförmige Lichtquellen. In diesen Fällen besitzen die Reflektoren eine Symmetrieebene, in der üblicherweise die Lichtquelle angeordnet ist. Symmetrieachse und Symmetrieebene werden für diese Beschreibung unter dem Begriff "Symmetriereferenz" zusammengefasst.

Ausserdem wird für diese Beschreibung der Begriff "Linse" auch für solche Umlenkelemente verwendet, bei denen die Lichteintritts- und Lichtaustrittsflächen nicht gewölbt, sondern plan sind, die aber eine fokussierende oder defokussierende (zerstreuende) Wirkung haben. Zu diesem Zweck besitzen sie gewölbte Mantelflächen, an denen vorwiegend Totalreflexion stattfindet. Die Bezeichnung "konkav" für die Mantelflächen bezieht sich auf die Krümmung zwischen den planen Ober- und Unterseiten der Linsen.

Einer der Vorteile der Erfindung ist, dass das von der Leuchte abgegebene Licht durch örtliche Veränderung der Abstrahlstelle entlang mindestens einer Geraden flexibel ausgerichtet werden kann.

In einer Ausführungsvariante der Erfindung umfasst die Leuchte eine oder mehrere Leuchtenelemente mit verschiebbaren Abstrahlstellen und mehrere elektrisch steuerbare Abstrahlstellen zum Positionieren des Lichtkegels der Leuchte.

Einer der Vorteile der Erfindung ist, dass die mechanische Konstruktion der Veränderbarkeit der oder jeder Abstrahlstelle kostengünstig realisierbar ist. So kann durch mechanisches Verschieben der Lichtquelle deren Abstrahlstelle verändert werden. Gemäß der Erfindung werden mehrere zueinander beabstandete Lichtquellen an der sogenannten Einstrahlungsfläche eines Umlenkelements angeordnet und diese werden elektrisch so angesteuert, dass entweder die eine oder die andere mit elektrischer Energie versorgt wird. Auf diese Weise kann bspw. zwischen zwei voneinander abweichenden Lichtkegeln ausgewählt werden. Zudem können auch beide Lichtquellen gemeinsam mit Energie versorgt werden, um einen gemeinsamen Lichtkegel zu erzeugen.

In einer anderen Ausführungsvariante umfasst die Leuchte mehrere Lichtquellen, welche auf einer Fläche angeordnet sind, wobei die Position jeder Abstrahlstelle einer Lichtquelle entlang von mindestens einer einen Winkel mit jeder Achse bildenden Geraden positionierbar ist, derart, dass abgestrahltes und/oder umgelenktes Licht jeder Leuchteneinheit als gemeinsamer Lichtkegel im Aussenraum veränderbar ist.

Gegenüber einer Leuchte mit einem grossen Reflektor mit einem oder mehreren Lichtquellen hat die erfindungsgemässe Leuchte den Vorteil, dass diese im Verhältnis zu besagtem grossen Reflektor mehrere kleine Umlenkelemente aufweist, um eine angenehme, nicht blendende Beleuchtung zu ermöglichen, wobei die Ausrichtung des erzeugten einzelnen Lichtkegels in verschiedenen Verschiebestellungen positionierbar ist. Die Grösse des Reflektors wird hier bezüglich der Abmessung der Lichtaustrittsfläche des Reflektors verstanden.

Des Weiteren weist die erfindungsgemässe Leuchte den Vorteil auf, dass gegenüber einer Leuchte mit einem grossen Reflektor die Abwärme der Lichtquellen kostengünstiger realisierbar ist, da die Lichtquellen auf einer grösseren Fläche verteilt sind.

Zudem fällt die Bauhöhe der erfindungsgemässen Leuchte mit mehreren Leuchtenelementen wesentlich geringer aus, so dass die Leuchte nicht nur als Stehleuchte, sondern auch als flache, einbaubare Deckenleuchte mit verstellbarem Lichtkegel geeignet ist.

In einer weiteren, nicht beanspruchten Ausführungsvariante umfasst die bzw. jede Lichtreflektormantelfläche eine Lichteintrittsöffnung und eine Lichtaustrittsöffnung, wobei die Querschnittsfläche der Lichteintrittsöffnung kleiner als die Querschnittsfläche der Lichtaustrittsöffnung ist. Der Innenraum des Reflektors ist dabei im Wesentlichen kegelförmig oder parabolisch ausgebildet.

Einer der Vorteile ist, dass durch die geometrische Ausgestaltung der Lichtreflektormantelfläche, etwa eines Reflektors, die Ausrichtung des abgestrahlten Lichts der Leuchte zusätzlich beeinflusst wird. Zudem kann die Mittelachse eines jeden Reflektors parallel zur Senkrechten oder in einem zur Senkrechten abweichenden Winkel angeordnet sein, was die Ausrichtung des Lichts bei der Leuchte zusätzlich beeinflusst.

Zum Positionieren und/oder Verändern von abgestrahltem und/oder reflektiertem Licht eines Leuchtenelements wird mittels Verschieben und elektrischem Steuern mindestens einer Abstrahlstelle einer Lichtquelle der erzeugte Lichtkegel abgelenkt.

Eine Leuchte umfasst mindestens eine Lichtquelle und mindestens ein Umlenkelement. Eine einzelne Lichtquelle und ein zugeordnetes Umlenkelement bilden ein sog. Leuchtenelement.

Ein *Lichtverteiler* umfasst eine Vielzahl von Umlenkelementen.

Im Folgenden werden anhand der beiliegenden Zeichnungen bevorzugte aber nicht beanspruchte Ausführungsbeispiele beschrieben. Es zeigen
Fig. 1a eine Ansicht von unten in den Innenraum des Reflektors eines Leuchtenelements einer Leuchte, sowie eine Ansicht auf einen Längsschnitt des Leuchtenelements, wobei die Lichtquelle im Zentrum des Reflektors positioniert ist;
Fig. 1b die Leuchte aus Fig. 1a, wobei die Abstrahlstelle gegenüber der ursprünglichen Position verändert wurde;
Fig. 2a und 2b in einem schematischen Diagramm die Lichtverteilung anhand eines Längsschnitts durch den Lichtkegel der Leuchte, wobei in Fig. 2a ein Schnitt durch einen Kegel erfolgt, welcher durch eine ungefähr zentrisch positionierte Abstrahlstelle hervorgerufen wird und wobei Fig. 2b einen Schnitt durch einen Kegel zeigt, welcher durch eine gegenüber der ursprünglichen Position veränderte Position der Abstrahlstelle hervorgerufen wird;
Fig. 3a und 3b einen schematisch dargestellten Lichtverlauf der in den Fig. 1a und 1b gezeigten Leuchte;
Fig. 4a und 4b in einer schematischen und vereinfachten dreidimensionalen Darstellung der in Fig. 1a und 1b gezeigten Leuchte;
Fig. 5 eine Ausführungsvariante der Leuchte in einer abgebrochenen Darstellung und einer Ansicht von oben in ein geöffnetes Gehäuse der Leuchte;
Fig. 6 eine Ansicht auf einen in Fig. 5 abgebrochen dargestellten Lichtverteiler mit mehreren Lichtreflektormantelflächen;
Fig. 7 eine Ausführungsvariante der Leuchte in einer geschnittenen und teilweise abgebrochenen Darstellung mit drei Leuchtenelementen, wobei durch Verschieben der Leuchtenelemente in Pfeilrichtung von rechts nach links die entsprechenden Lichtkegel ausgerichtet wurden, was anhand der Achsen K veranschaulicht ist;
Fig. 8 eine abgebrochene perspektivische Darstellung einer Leuchte in einer Ansicht von unten und
Fig. 9 schematisch ein Leuchtenelement der abgebrochen dargestellten Leuchte mit mehreren Lichtquellen, wobei durch wahlweise Ansteuerung einer der beiden Lichtquellen die Position der aktiven Abstrahlstelle veränderbar ist.
Fig. 10 eine andere Ausführungsform eines Umlenkelements
Fig. 11 einen Schnitt durch eine weitere Ausführungsform eines Umlenkelements.
Fig. 12 das in Fig. 11 gezeigte Umlenkelement mit Beispielen des Strahlenganges.

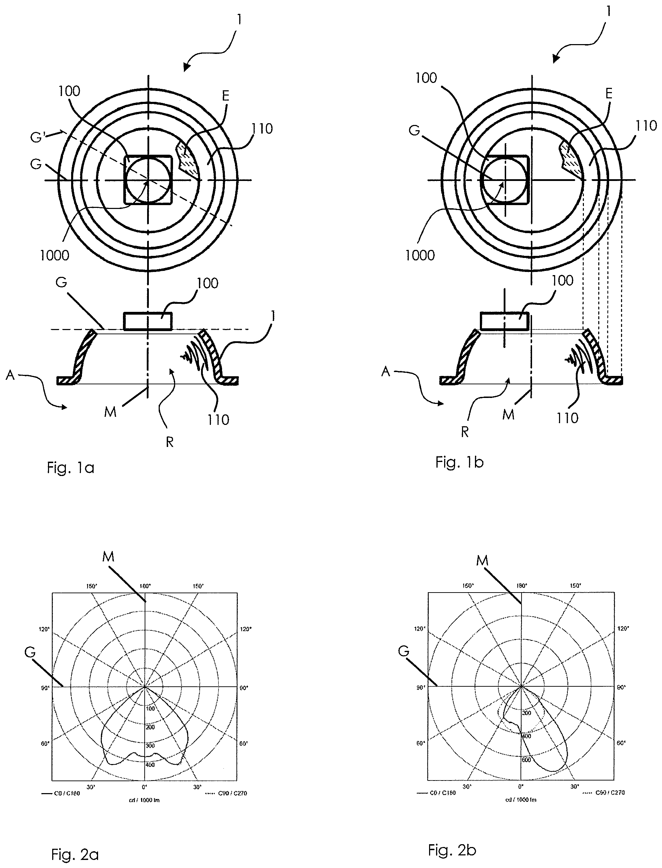

Figur 1a illustriert eine Leuchte 1 mit einem einen Innenraum R und eine Achse M umschliessenden, an besagten Innenraum angrenzende Lichtreflektormantelfläche 110 und mit einer Lichtquelle 100 mit mindestens einer Abstrahlstelle 1000 zum Abstrahlen von Licht in den Innenraum, wobei die Position der Abstrahlstelle 1000 entlang von mindestens einer einen Winkel mit der Achse M bildenden Geraden G veränderbar ist. Die dargestellte Position der Lichtquelle ist derart, dass der mittels abgestrahlten und/oder reflektierten Lichts gebildete Lichtkegel der Leuchte 1 eine symmetrische Form aufweist.

Die Abstrahlstelle 1000 kann eindimensional entlang einer Geraden G oder mehrdimensional entlang einer Geraden G und weiterer Geraden G' verändert werden. Die Position der Abstrahlstelle 1000 kann also vorzugsweise im Bereich der Lichteintrittsöffnungsfläche, welche auch als Einstrahlöffnungsfläche bezeichnet wird, verändert werden.

Der Innenraum R der Leuchte 1 weist eine diesen nach oben begrenzende Einstrahlöffnungsfläche E auf. Die Lichtquelle 100 ist derart angeordnet, dass deren Abstrahlstelle 1000 vorzugsweise in besagter Einstrahlungsöffnungsfläche liegt, so dass das gesamte abgestrahlte Licht in den Innenraum R eintritt und die Lichtquelle 100 zugleich bis an den Rand der Einstrahlungsöffnungsfläche positioniert werden kann, um eine möglichst grosse Ausrichtung des Lichts zu erreichen. Zudem wird dadurch verhindert, dass Licht hinter die Einstrahlöffnungsfläche gestreut wird.

Figur 1b illustriert die Leuchte 1, wobei die Abstrahlstelle 1000 gegenüber der in Figur 1a dargestellten Abstrahlstelle verschoben worden ist. Die Verschiebbarkeit auf der mindestens einen Geraden G kann realisiert sein durch eine mechanische Verschiebung eines oder mehrer Lichtquellen bzw. der Abstrahlstelle der oder jeder Lichtquelle in Bezug auf die Achse M.

Die Verschiebbarkeit kann auch realisiert sein durch eine Vielzahl von elektrisch individuell ansteuerbaren Lichtquellen, bspw. in einer Matrix. Durch elektrische Steuerung mindestens einer der Lichtquellen wird die Aktivierung der Abstrahlstelle 1000 so gewählt, dass der sich bildende Lichtkegel des Leuchtenelements der Leuchte 1 von der mittleren Achse M um den spitzen Ablenkwinkel Ω abweicht, welcher zwischen der Linie K und der Achse M gebildet wird. Dadurch wird eine flexible Ausrichtung der Beleuchtung einer zu beleuchtenden Oberfläche erreicht.

Figuren 2a und 2b illustrieren jeweils in einem schematischen Diagramm die Lichtverteilung der Leuchte aus den Figuren 1a und 1b anhand eines Längsschnitts durch den Lichtkegel der Leuchte 1.

Figur 2a zeigt zwei Lichtverteilungskurven, wobei eine in gestrichelter und eine in ausgezogener Linie dargestellt ist. Die beiden Schnitte, aus welchen die Lichtverteilungskurven hervorgehen, sind um einen rechten Winkel versetzt zueinander entlang der Achse M erfolgt. Es ist ersichtlich, dass beide Lichtverteilungskurven nahezu deckungsgleich sind, wonach die Abstrahlstelle der Lichtquelle ebenfalls in bzw. auf der Achse M positioniert ist.

Figur 2b zeigt ebenfalls Lichtverteilungskurven, welche in gestrichelter und in durchgezogener Linie dargestellt sind. Gegenüber der obgenannten Darstellung unterscheiden sich die vorliegenden beiden Lichtverteilungskurven, da der in Figur 1b dargestellte Abstrahlpunkt nicht mehr in bzw. auf der Achse M, sondern in einer entlang der Geraden G veränderten Lage, liegt.

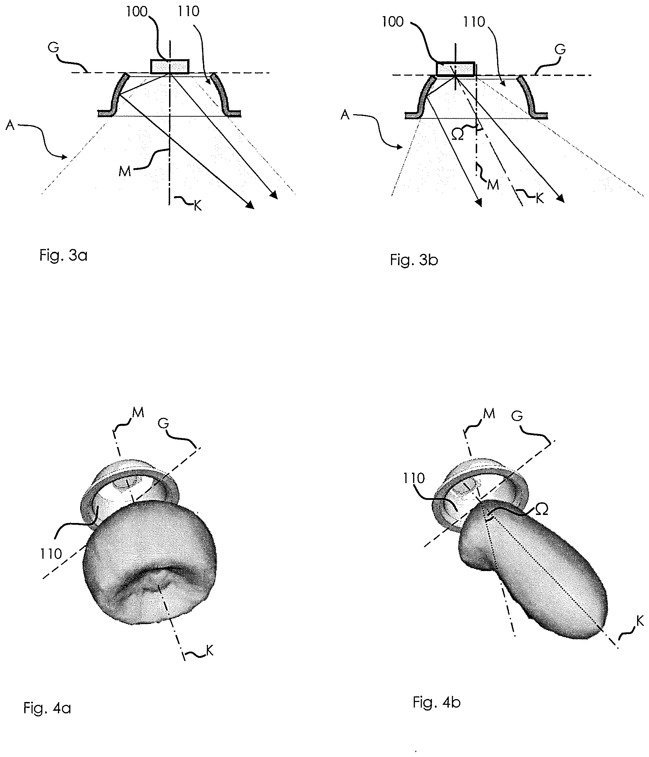

Figuren 3a und 3b zeigen einen schematisch dargestellten Lichtverlauf der in den Figuren 1a und 1b gezeigten Leuchte 1.

Figuren 4a und 4b zeigen in einer schematischen und vereinfachten dreidimensionalen Darstellung der in Figuren 1a und 1b gezeigten Leuchte.

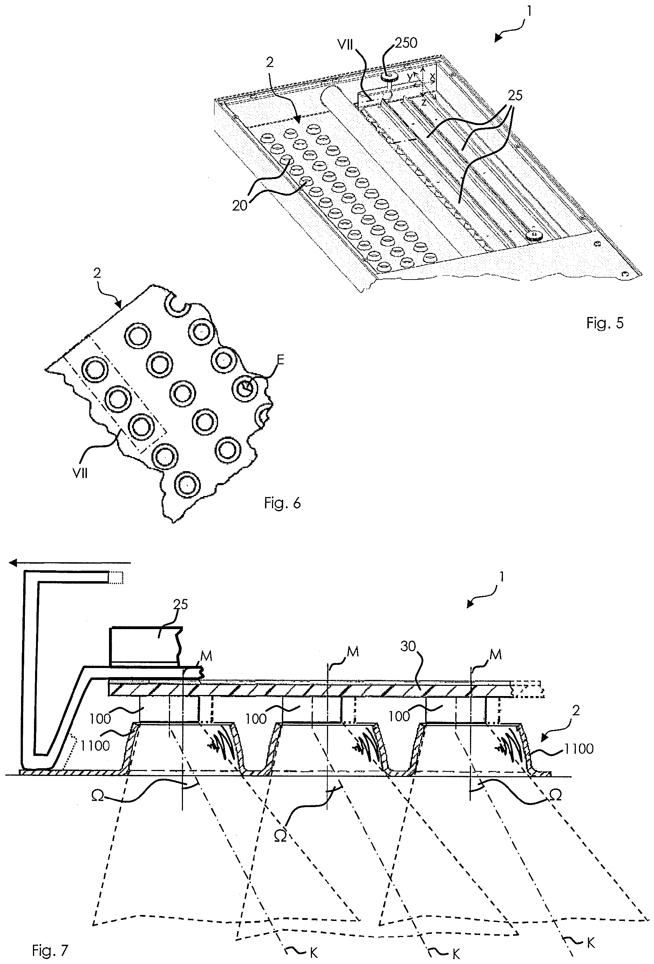

Figur 5 illustriert in einer perspektivischen abgebrochenen Darstellung eine Leuchte 1 in einer Ansicht von oben. Dabei ist ein Gehäuse vorhanden, in welchem mehrere als Reflektoren ausgebildete Lichtreflektormantelflächen vorhanden sind.

Eine Verstellvorrichtung 25 der Leuchte 1 ist in deren rechten Hälfte ersichtlich. Eine Verstellvorrichtung in der linken Hälfte ist aus Gründen der verbesserten Darstellung nicht gezeichnet. Die Verstellvorrichtung 25 ist abgebrochen in der Figur 7 dargestellt. Sie dient zum Halten und lösbaren Positionieren der Lichtquellen 100 in verschiedenen Verstellpositionen.

Die Verstellvorrichtung 25 ist in einer Ausführungsvariante der Leuchte nicht nur entlang der Geraden G, sondern auch entlang der Achse M verstellbar gelagert, so dass zur Veränderung des abgestrahlten Lichts die Lichtquellen 100 durch An- oder Abheben höhenverstellbar sind.

Die Verstellvorrichtung 25 umfasst zum lösbaren Positionieren der Lichtquellen in verschiedenen Verstellpositionen entsprechende Verstell- und Befestigungsmittel 250. Ein solches Mittel ist bspw. als Arretierschraube ausgebildet, welche in einer hier nicht weiter dargestellten Öffnung, bspw. im Deckel des Gehäuses, lösbar arretiert werden kann, um die Lichtquellen 100 durch Verschieben und/oder durch An- oder Abheben der Verstellvorrichtung 25 in einer entsprechenden Position zu befestigen.

Die Verstellvorrichtung 25 kann manuell oder motorisch betrieben werden. Ein motorischer Antrieb ist bspw. durch mindestens eine durch einen Elektroantrieb versehene Spindelachse realisiert, welche zum Verschieben der Lichtquellen ausgebildet ist.

Figur 6 illustriert in einer abgebrochenen Darstellung eine Anordnung mehrerer Lichtreflektormantelflächen 110, wie sie auch in Figur 5 sowohl in der linken, wie auch in der rechten Hälfte der Leuchte ersichtlich sind. Die bzw. jede Lichtreflektormantelfläche 110 umfasst eine Lichteintrittsöffnung und eine Lichtaustrittsöffnung, wobei die Querschnittsfläche der Lichteintrittsöffnung kleiner als die Querschnittsfläche der Lichtaustrittsöffnung ist. Die Lichteintrittsöffnung weist eine als Lichteintrittsöffnungsfläche oder Einstrahlöffnungsfläche E bezeichnete und hier abgebrochen dargestellte Fläche auf.

Die Lichtreflektormantelfläche 110 ist im Wesentlichen als kegelförmige oder parabolische Fläche eines Reflektors ausgebildet, wobei die horizontale Querschnittsfläche des Reflektors rund oder vieleckig ist. Figur 6 illustriert beispielhaft kreisrunde Querschnittsflächen.

Reflektoren werden etwa dadurch hergestellt, indem aus einem Blech mit spiegelnder Oberfläche im Tiefzugverfahren mehrere Durchgangsöffnungen mit der gewünschten Reflektormantelfläche eingeformt werden. Die Verspiegelung kann auch nachträglich auf das Blech aufgebracht werden. Die Vielzahl gemeinsam auf einer Fläche angeordneter Reflektoren 1100 wird auch als Lichtverteiler 2 bezeichnet.

Ein Lichtverteiler 2 kann auch im Spritzgussverfahren oder durch Thermoverformung aus Kunststoff hergestellt werden, wobei die für die Lichtreflektion relevante Lichtreflektormantelfläche mindestens stellenweise spiegelnd sein muss. Dies kann bspw. durch Bedampfen der Oberfläche erzielt werden.

Der Lichtverteiler 2 kann auch in sog. Spiegelrastertechnik realisiert sein, indem mehrere Längs- und Querlamellen gitterartig miteinander verbunden werden. Die Lamellen weisen dabei einen ungefähr V-förmigen oder trapezförmigen Querschnitt auf, wobei die Lichtreflektormantelfläche diesfalls durch aneinander angrenzende Lamellenabschnitte gebildet wird. Deren reflektierende bzw. spiegelnde Oberfläche kann parabolisch sein.

Die oder jede Lichtreflektormantelfläche kann durch Oberflächenbehandlung veredelt werden, um eine optimale Reflektion des Lichts zu erzielen. Reflektoren können auch als Einzelbauteile in eine Haltefläche, etwa ein Blech mit Öffnungen, zu deren Befestigung eingesetzt werden. Anstelle eines Blechs kann ein mehr oder weniger lichtdurchlässiges Material, bspw. Kunststoff, verwendet werden, um die Einzelbauteile aufzunehmen.

Figur 7 illustriert in einer Schnittdarstellung einen abgebrochen dargestellten Teil der in Figur 5 gezeigten Leuchte 1, wobei die drei Lichtquellen 100 von einer ersten in gestrichelter Linie dargestellten Position in Pfeilrichtung in eine zweite Position nach links verschoben worden sind. Dies bewirkt eine Ausrichtung der dargestellten und sich teilweise überschneidenden Lichtkegel, bspw. zur optimierten Beleuchtung einer Arbeitsfläche.

Die Leuchte kann in einer anderen vorteilhaften Anwendung zur flexibel positionierbaren Beleuchtung von Produktauslagen in Einkaufsläden genutzt werden.

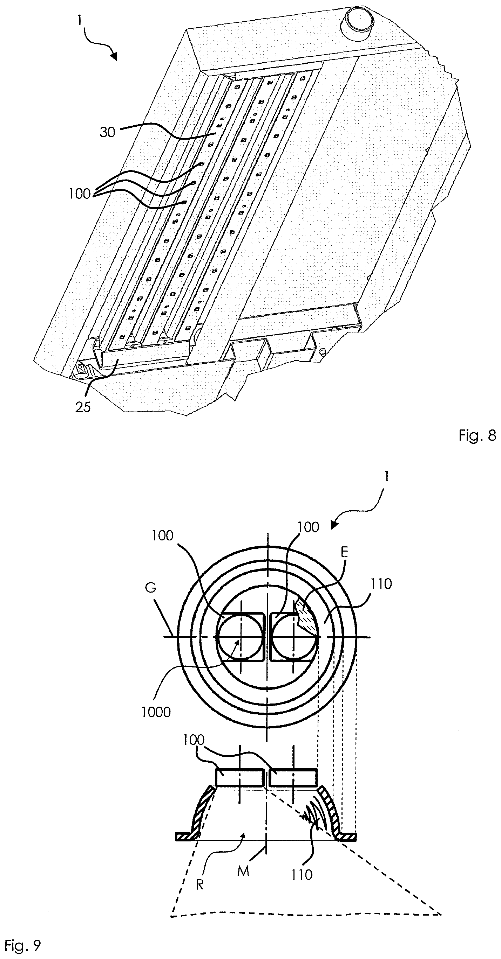

Figur 8 illustriert eine abgebrochene perspektivische Darstellung einer Leuchte 1 in einer Ansicht von unten. Bezugszeichen 30 bezeichnet ein Verbindungs- und/oder Trägermittel, welches vorzugsweise als gedruckte Schaltung (PCB) ausgebildet ist, auf welchem die als Leuchtdioden ausgebildeten Lichtquellen 100 in Reihe angeordnet sind. Das bzw. die Verbindungs- und/oder Trägermittel dienen zur Aufnahme der als Leuchtdioden ausgebildeten Lichtquellen und zu deren Befestigung in entsprechenden Abständen. Zudem sind die Leuchtdioden elektrisch mit einer nicht dargestellten elektrischen Energiequelle, bspw. einem Vorschaltgerät, verbunden. Die Leuchte 1 kann ausgebildet sein, um jede Leuchtdiode einzeln oder auch gemeinsam mit Energie zu versorgen.

Das Verbindungs- und/oder Trägermittel 30 dient vorliegend zum Aufnehmen der auf PCB Bahnen befestigten und verdrahteten Leuchtdioden, wobei das PCB mit dem Trägermittel bspw. verklebt oder verschraubt wird. Das Verbindungs- und/oder Trägermittel 30 dient zudem als Kühlelement mit Kühlfahnen, um die Verlustwärme der Lichtquellen an die Umluft abzuführen. Des Weiteren ist das Verbindungs- und/oder Trägermittel 30 als Verschiebemechanik ausgelegt, um die Ausrichtung des abgestrahlten Lichts zu verändern, indem die Lichtquellen in verschiedenen Positionen arretierbar sind.

Anstatt die Lichtquellen bezüglich der Reflektoren des Lichtverteilers zu verschieben, ist in einer Ausführungsvariante vorgesehen, die Lichtquellen stationär anzuordnen, bspw. indem diese mit dem Gehäuse der Leuchte verbunden sind, wobei zur Positionierung des oder der Lichtkegel die entsprechenden Lichtreflektormantelflächen der Reflektoren bezüglich der fest positionierten Abstrahlstellen jeder Lichtquelle verändert werden. Dies hat zudem den Vorteil, dass das Gehäuse der Leuchte gleichzeitig als Kühlelement benutzt werden kann.

Figur 9 illustriert eine schematische Darstellung einer Leuchte 1 mit mehreren Lichtquellen 100, wobei durch wahlweise Ansteuerung einer der beiden Lichtquellen 100 die entsprechende Abstrahlstelle 1000 der Leuchte entlang der Geraden G veränderbar ist. Es kann die eine oder die andere Lichtquelle 100 oder beide gemeinsam angesteuert werden. Unter Ansteuerung wird nicht nur das Aktivieren oder Desaktivieren, sondern auch eine leistungsabhängige Steuerung, bspw. Dimmen, verstanden.

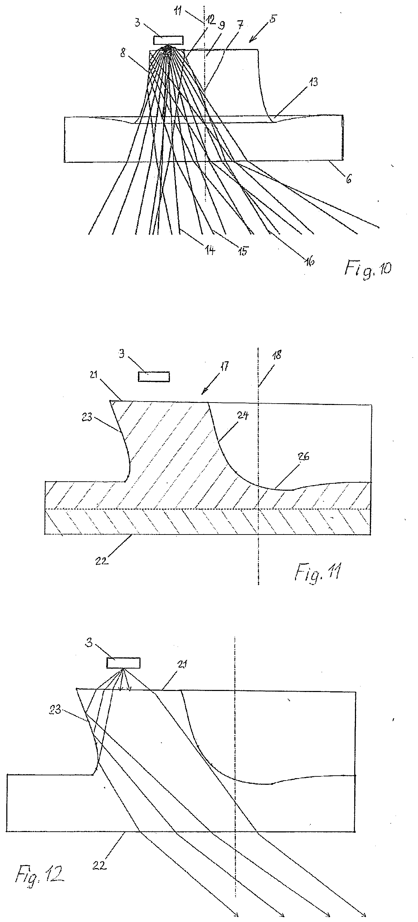

Das in den Fig. 10 bis 12 gezeigten Umlenkelemente 4 bzw. 17 nutzten zum Umlenken der Lichtstrahlen zusätzlich zur Reflexion auch noch die Refraktion. Bei dem in Fig. 10 gezeigten Ausführungsbeispiel ist das Umlenkelement als Linse 5 mit einer planen Unterseite 6 und einer planen Oberseite 7, einer konvexen äusseren Mantelfläche 8 und einer durch eine zentrale Vertiefung 9 definierte inneren Mantelfläche 12 ausgebildet. Um diese Linse herum verläuft eine flache Vertiefung 13. Die Oberflächen der Mantelflächen sind poliert, um Strahlen, die aus dem Inneren der Linse auf sie auftreffen, total zu reflektieren. Zusätzlich können diese Oberflächen verspiegelt sein, z.B. durch eine aufgedampfte Reflexionsschicht.

Die Linse und die umlaufende Vertiefung sind rotationssymmetrisch um die Achse 11.

In Fig. 10 sind auch einige exemplarische Strahlengänge für eine ausserhalb der Symmetrieachse angeordnete Lichtquelle 13 gezeigt. Der Strahl 14 gelangt von der Lichtquelle nahezu ungebrochen durch die Linse, weil er nahezu senkrecht auf ihre plane Oberseite trifft. Der Strahl 15 wird an der Oberseite zur Achse hin gebrochen und gelangt dann an die äussere Mantelfläche, wo Totalreflexion stattfindet. Beim Austritt an der Unterseite wird der Strahl von der Achse weg gebrochen. Der Strahl 16 wird an der Oberseite ebenfalls zur Achse hin gebrochen und gelangt dann an die innere Mantelfläche, wo wiederum Totalreflexion stattfindet. Bei seinem Austritt an der Unterseite wird er von der Achse weg gebrochen.

In den Fig. 11 und 12 ist eine Ausführungsform mit einer Linse 17 gezeigt, die nicht rotationssymmetrisch ist, sondern asymmetrisch, und sich ringsegment- oder hufeisenförmig um eine Achse 18 herum erstreckt. Sie besitzt eine plane Oberseite 21, eine plane Unterseite 22, eine äussere konkave Mantelfäche 23 und eine innere konkave Mantelfläche 24. Entlang der inneren Mantelfläche verläuft eine flache Vertiefung 26. Die Symmetriereferenz 27 dieser Linse verläuft ausserhalb. In Fig. 12 sind einige Beispiele des Strahlenganges dieser Linse gezeigt.

Es ist ohne weiteres ersichtlich, dass der grösste Teil der von der im Bild links von der Symmetrieachse bzw. -referenz angeordneten Lichtquelle ausgehenden Strahlen durch das Umlenkelement 4 bzw. 17 nach rechts gelenkt werden. Es ergibt sich also grundsätzlich der gleiche Effekt, wie beim ersten Ausführungsbeispiel mit den Reflektoren allein. Die Lichtverteilung ist ähnlich wie in Fig. 2b gezeigt. Allerdings wird der Effekt durch die Kombination mit der Refraktion durch die Linse 4 noch verstärkt. Mit der Refraktion durch eine Linse allein, ohne die reflektierende Fläche der Flanke 10 würde sich auch schon ein Umlenkeffekt ergeben, der allerdings wesentlich schwächer ist.

Für eine Leuchte wird eine Vielzahl von Umlenkelementen zu einer Anordnung, wie in Fig. 5 gezeigt, flächig aneinandergereiht. In der Praxis erfolgt dies so, dass die Vielzahl von Umlenkelementen durch ein geeignetes Verfahren, z.B. Spritzguss, Thermoverformung etc., in einer Platte aus einem geeigneten Kunststoff ausgebildet sind.

Es ist auch möglich, die Linsen einzeln herzustellen und auf einer ebenen Platte in der gewünschten Anordnung zu montieren.

Eine geringe Lichtmenge gelangt im Bereich der Vertiefungen 13 bzw. 26 in den die Linse umgebenden Bereich, d.h. im Fall einer Platte mit einer Vielzahl von Umlenkelementen in die Bereiche zwischen den einzelnen Umlenkelementen, wodurch die Platte ausgeleuchtet wird. Durch die Formung der Umlenkelemente und ggf. durch die Anordnung von Streuflächen kann diese Lichtmenge beeinflusst werden.

## Patentansprüche

1. Leuchte (1) mit einer Lichtquelle (13, 100), einem in Richtung des abgestrahlten Lichts vor der Lichtquelle angeordneten, bezüglich einer Symmetriereferenz symmetrischen Umlenkelement zum Umlenken der von der Lichtquelle kommenden Lichtstrahlen und Mitteln zur Positionierung der Lichtquelle ausserhalb der Symmetriereferenz derart, dass der von der Leuchte abgegebene Lichtkegel im Aussenraum (A) veränderbar ist, wobei die Leuchte (1) mehrere elektrisch steuerbare Lichtquellen zum Positionieren des Lichtkegels der Leuchte (1) umfasst, **dadurch gekennzeichnet, dass** das Umlenkelement eine rotationssymmetrische Linse und die Symmetriereferenz eine Symmetrieachse (11) ist, wobei eine Mantelfläche der Linse mit einer reflektierenden Beschichtung versehen ist.

2. Leuchte (1) gemäss Anspruch 1, **dadurch gekennzeichnet, dass** die mehreren elektrisch steuerbaren Lichtquellen zueinander beabstandet und an einer Einstrahlungsfläche des Umlenkelements angeordnet sind.

3. Leuchte (1) gemäss einem der vorgenannten Ansprüche, **dadurch gekennzeichnet, dass** jede Lichtquelle (100) als Leuchtdiode mit einer ungefähr punktförmigen Abstrahlstelle (1000) ausgebildet ist.

4. Leuchte (1) gemäss einem der vorgenannten Ansprüche, **dadurch gekennzeichnet, dass** die mehreren Lichtquellen (100) jeweils eine Abstrahlstelle (1000) aufweisen und auf einer Fläche angeordnet sind, wobei die Position jeder Abstrahlstelle (1000) entlang von mindestens einer einen Winkel mit jeder Achse (M) bildenden Geraden (G) positionierbar ist, derart, dass abgestrahltes und/oder umgelenktes Licht der Leuchte als gemeinsamer Lichtkegel im Aussenraum (A) veränderbar ist.

## Claims

1. A luminaire (1) having a light source (13, 100), a deflecting element arranged in front of the light source in the direction of the radiated light and symmetrical with respect to a symmetry reference for deflecting the light beams coming from the light source, and means for positioning the light source outside the symmetry reference in such a way that the light cone emitted by the luminaire can be varied in an exterior space (A), wherein the luminaire (1) comprises a plurality of electrically controllable light sources for positioning the light cone of the luminaire (1), **characterized in that** the deflecting element is a rotationally symmetrical lens and the symmetry reference is an axis of symmetry (11), wherein the lateral surface of the lens is provided with a reflective coating.

2. A luminaire (1) according to claim 1, **characterized in that** the plurality of electrically controllable light sources are spaced apart from one another and are arranged on an irradiation surface of the deflecting element.

3. A luminaire (1) according to one of the aforementioned claims, **characterized in that** each light source (100) is formed as a light-emitting diode having an approximately punctiform radiation point (1000).

4. A luminaire (1) according to one of the aforementioned claims, **characterized in that** the plurality of light sources (100) each comprise a radiation point (1000) and are arranged on a surface, wherein the position of each radiation point (1000) can be positioned along at least one straight line (G) forming an angle with each axis (M), in such a manner that emitted and/or deflected light of the luminaire can be varied as a common light cone in an exterior space (A).

## Revendications

1. Luminaire (1) comportant une source lumineuse (13, 100), un élément déflecteur disposé devant la source lumineuse dans la direction de la lumière rayonnée et symétrique par rapport à une référence de symétrie pour dévier les faisceaux lumineux provenant de la source lumineuse, et des moyens pour positionner la source lumineuse hors de la référence de symétrie de sorte que le cône lumineux émis par le luminaire peut être modifié dans l'espace extérieur (A), le luminaire (1) comprenant une pluralité de sources lumineuses pouvant être commandées électriquement pour positionner le cône lumineux du luminaire (1), **caractérisé en ce que** l'élément déflecteur est une lentille à symétrie de rotation et la référence de symétrie est un axe de symétrie (11), une surface périphérique de la lentille étant munie d'un revêtement réfléchissant.

2. Luminaire (1) selon la revendication 1, **caractérisé en ce que** la pluralité de sources lumineuses à commande électrique sont espacées les unes des autres et sont disposées sur une surface d'irradiation de l'élément déflecteur.

3. Luminaire (1) selon l'une des revendications précédentes, **caractérisé en ce que** chaque source lumineuse (100) est conçue comme une diode électroluminescente avec un point d'émission (1000) approximativement en forme de point.

4. Luminaire (1) selon l'une des revendications précédentes, **caractérisé en ce que** la pluralité de sources lumineuses (100) présente chacune un point d'émission (1000) et sont disposées sur une surface, la position de chaque point d'émission (1000) pouvant être positionnée le long d'au moins une ligne droite (G) formant un angle avec chaque axe (M), de sorte que la lumière émise et/ou déviée du luminaire peut être modifiée en un cône lumineux commun dans l'espace extérieur (A).
